# EUROPEAN PATENT SPECIFICATION

(11) **EP 3 966 873 B1**
(45) Date of publication and mention of the grant of the patent: **14.12.2022**
(21) Application number: 20723124.2
(22) Date of filing: 04.05.2020
(51) Int. Cl.: H01L 33/58, G02B 27/14, G03B 21/20, H01L 33/64, H01L 33/50, F21V 5/04, F21K 9/69, G03B 21/16, G02B 7/02

(54) **LIGHTING SYSTEM INCLUDING A TRUNCATED BALL LENS**
BELEUCHTUNGSSYSTEM MIT EINER VERKÜRZTEN KUGELLINSE
SYSTÈME D'ÉCLAIRAGE AVEC UNE LENTILLE À BOULE TRONQUÉE

(30) Priority: 09.05.2019 EP 19173481
(43) Date of publication of application: 16.03.2022
(73) Proprietor: Signify Holding B.V., 5656 AE Eindhoven (NL)
(72) Inventor: CORNELISSEN, Hugo, Johan, 5656 AE Eindhoven (NL); VDOVIN, Olexandr, Valentynovych, 5656 AE Eindhoven (NL); BENOY, Daniël, Anton, 5656 AE Eindhoven (NL); VAN DER LUBBE, Marcellus, Jacobus, Johannes, 5656 AE Eindhoven (NL); HOELEN, Christoph, Gerard, August, 5656 AE Eindhoven (NL)
(74) Representative: Mallens, Erik Petrus Johannes
(86) International application number: PCT/EP2020/062281
(87) International publication number: WO 2020/225195

(56) References cited:
- EP-A2- 1 191 608
- EP-A2- 1 605 199
- WO-A2-01/27962
- GB-A- 1 167 300
- US-A1- 2007 290 383
- LIN WANG ET AL: "Wide-field high-resolution solid immersion fluorescence microscopy applying an aplanatic solid immersion lens", APPLIED OPTICS,, vol. 49, no. 31, 1 November 2010 (2010-11-01), pages 6160-6169, XP001558381, OPTICAL SOCIETY OF AMERICA, WASHINGTON, DC; US ISSN: 0003-6935, DOI: 10.1364/AO.49.006160
- CHEN L C ET AL: "Combinational system of a truncated ball lens and a hyperbolic lens for collimating a highly divergent source", APPLIED OPTICS, vol. 43, no. 35, 10 December 2004 (2004-12-10), pages 6380-6383, XP002795183, OPTICAL SOCIETY OF AMERICA, WASHINGTON, DC; US ISSN: 0003-6935, DOI: 10.1364/AO.43.006380 cited in the application

## Description

### FIELD OF THE INVENTION

The invention relates to a system, especially a lighting system, and to a lighting device comprising such lighting system.

### BACKGROUND OF THE INVENTION

Lighting devices and systems are known in the art. US2012/0268945 (or US8616734B1), for instance, describes an LED illumination device, comprising: a light emitting diode (LED); a generally curved lens having a flat surface positioned adjacent to a light emitting surface face of the LED; wherein the lens has an index of refraction relative to a light wavelength emitted by the LED of greater than about 1.65; a thermal cup comprising a hollow post; a circuit board comprising a hole, wherein the hole is disposed to receive the hollow post, wherein the circuit board is configured to move along an axis that is parallel to a surface of the circuit board; a spring disposed around the hollow post; and a wire, wherein a first end of the wire is connected to the light emitting diode, wherein a second end of the wire is connected to the circuit board, and wherein the wire passes through the hollow portion of the hollow post.

EP1191608A2 discloses a light emitting device with an improved light extraction efficiency having a stack of layers including semiconductor layers comprising an active region. The stack is bonded to a transparent lens having a refractive index for light emitted by the active region greater than about 1.5.

EP1605199 A2 discloses an illumination device with a wavelength converting element, such as a phosphor layer, that is physically separated from a primary light source, such as one or more light emitting diodes, a xenon lamp or mercury lamp. A portion of primary light is combined with secondary light emitted by the wavelength converting element upon excitation by another portion of the the primary light.

Lin Wang et. al., "Wide-field high-resolution solid immersion fluorescence microscopy applying an aplanatic solid immersion lens", Applied Optics, Optical Society of America, Washington DC, US, Vol. 49, No 31, 1 November 2010, pages 6160 - 6169, discloses the use of aplanatic solid immersion lenses (ASILs) made of high refractive index optical materials in wide-field high-resolution optical microscopy.

### SUMMARY OF THE INVENTION

A possible architecture for e.g. a laser-based lighting system (for instance for GOBO ("goes before optics" or "goes between optics") applications), with a reflective phosphor may comprise a pump laser, a lens, a dichroic beam splitter 1, and a ceramic phosphor. For instance, light from one or more blue pump lasers may be mixed in a mix rod and collimated with a lens. After passing a dichroic beam splitter the pump light is focused onto the ceramic phosphor with e.g. a tandem of condenser lenses. The converted light is collected by the same condenser lenses and directed by the dichroic mirror towards the exit of the lighting system.

It appears, however, that lenses are not perfectly transparent and may absorb a little light. The power density of the blue pump light inside the second (smaller) condenser lens can be so high that fracture occurs due to thermally induced stresses and the limited thermal conductivity of the lens. Hence, thermally induced stresses in the condenser lens may occur which may lead to damage, fracture, or even explosion of the lens. Further, it also appears that the image quality of the converted light beam at a Gobo of the lighting system may not be sufficiently high due to spherical aberrations in the condenser lenses. Further, high quality aspherical condenser lenses may be relatively expensive.

Hence, it is an aspect of the invention to provide an alternative lighting system (or lighting device) (or condenser lens), which preferably further at least partly obviates one or more of above-described drawbacks. The present invention may have as object to overcome or ameliorate at least one of the disadvantages of the prior art, or to provide a useful alternative.

In an aspect, the invention provides a system comprising (i) a light emitting layer, (ii) a first lens, and a thermal conductor. Especially, the light emitting layer comprises luminescent material. The luminescent material is especially configured to generate luminescent material light upon excitation with light that can be absorbed and converted by the luminescent material into luminescent material light. Hence, especially the luminescent material may be configured to generate luminescent material light upon excitation with light source light from a first laser light source comprising a wavelength λ₁ selected from a wavelength in the UV, visible, and infrared, where the luminescent material can be excited. Further, the light emitting layer comprises a light receiving area having a light receiving area size A₁. Especially, the first lens comprises a truncated ball shaped lens having a curved lens surface having a radius Ro relative to a central point (O), and a planar lens surface configured at a first distance d₁ from the central point (O). further, the planar lens surface has a planar lens surface area size A₂. Especially, the first lens comprises a lens material having an index of refraction n (further also indicated as "index of refraction") at said predetermined wavelength λ₁, wherein d₁=x^{∗}R₀/n, wherein in specific embodiments 0.9≤x≤1.1. Especially, the planar lens surface area size A₂ is larger than the light receiving area size A₁ (of the light receiving area). Especially, the first lens is configured to concentrate light (such as especially first light source light) received at the curved lens surface to provide (focused or concentrated) light (i.e. especially thus first light source light) emanating from the planar lens surface. Especially, the planar lens surface is directed to the light receiving area. Further, especially the thermal conductor is configured in thermal contact with one or more of the light emitting layer and the first lens. Hence, in a specific embodiment the invention provides a system comprising (i) a light emitting layer, (ii) a first lens, and a thermal conductor, wherein: (I) the light emitting layer comprises luminescent material, wherein the luminescent material is configured to generate luminescent material light upon excitation with light source light from a first light source comprising a wavelength λ₁ where the luminescent material can be excited, wherein the light emitting layer comprises a light receiving area having a light receiving area size A₁; (II) the first lens comprises a truncated ball shaped lens having a curved lens surface having a radius R₀ relative to a central point (O), and a planar lens surface configured at a first distance d₁ from the central point (O), wherein the planar lens surface has a planar lens surface area size A₂, wherein the first lens comprises a lens material having an index of refraction n at a predetermined wavelength λ₁ selected from a wavelength in the UV, visible, and infrared, wherein d₁=x^{∗}R₀/n, wherein 0.9≤x≤1.1, wherein the planar lens surface area size A₂ is larger than the light receiving area size A₁, wherein the first lens is configured to concentrate light (especially first light source light) received at the curved lens surface to provide (focused) light (especially the first light source light) emanating from the planar lens surface, wherein the planar lens surface is directed to the light receiving area; and (III) the thermal conductor is configured in thermal contact with one or more of the light emitting layer and the first lens.

With such system thermal management may be improved, leading to less product failures and allowing higher outputs. Thermal management may be improved in relation to the lens and/or in relation to the luminescent material. Further, spherical aberration may be reduced, e.g. allowing the system to be used in or for projection applications. Further, optical efficiencies may be higher because there may be less spill light or stray light. Also, less light may be absorbed in e.g. apertures and/or beam stops.

As indicated above, the system comprises (i) a light emitting layer, (ii) a first lens, and a thermal conductor. Hence, though the system is also defined in relation to light (source light) of a light source, the light source is not necessarily part of the system. In such embodiments, the system may e.g. be applied in a lighting system (with a light source). In some embodiments, however, a light source is comprised by the system. Hence, in such embodiments the system may be a lighting system.

The light emitting layer comprises luminescent material. Hence, instead of the term "light emitting layer", also the term "luminescent material comprising layer" may be applied. The term "luminescent material" especially refers to a material that can convert first radiation, especially one or more of UV radiation and blue radiation, into second radiation. In general, the first radiation and second radiation have different spectral power distributions. Hence, instead of the term "luminescent material", also the terms "luminescent converter" or "converter" may be applied. In general, the second radiation has a spectral power distribution at larger wavelengths than the first radiation, which is the case in the so-called downconversion. In specific embodiments, however the second radiation has a spectral power distribution with intensity at smaller wavelengths than the first radiation, which is the case in the so-called up-conversion. In embodiments, the "luminescent material" may especially refer to a material that can convert radiation into e.g. visible and/or infrared light. For instance, in embodiments the luminescent material may be able to convert one or more of UV radiation and blue radiation, into visible light. The luminescent material may in specific embodiments also convert radiation into infrared radiation (IR). Hence, upon excitation with radiation, the luminescent material emits radiation. In general, the luminescent material will be a down converter, i.e. radiation of a smaller wavelength is converted into radiation with a larger wavelength (λₑₓ<λₑₘ), though in specific embodiments the luminescent material may comprise down-converter luminescent material, i.e. radiation of a larger wavelength is converted into radiation with a smaller wavelength (λₑₓ>λₑₘ).

In embodiments, the term "luminescence" may refer to phosphorescence. In embodiments, the term "luminescence" may also refer to fluorescence. Instead of the term "luminescence", also the term "emission" may be applied. Hence, the terms "first radiation" and "second radiation" may refer to excitation radiation and emission (radiation), respectively.

The term "luminescent material" may also refer to a plurality of different luminescent materials. Examples of possible luminescent materials are indicated below.

In embodiments, luminescent materials are selected from garnets and nitrides, especially doped with trivalent cerium or divalent europium, respectively. Embodiments of garnets especially include A₃B₅O₁₂ garnets, wherein A comprises at least yttrium or lutetium and wherein B comprises at least aluminum. Such garnets may be doped with cerium (Ce), with praseodymium (Pr) or a combination of cerium and praseodymium; especially however with Ce. Especially, B comprises aluminum (Al), however, B may also partly comprise gallium (Ga) and/or scandium (Sc) and/or indium (In), especially up to about 20% of Al, more especially up to about 10 % of Al (i.e. the B ions essentially consist of 90 or more mole % of Al and 10 or less mole % of one or more of Ga, Sc and In); B may especially comprise up to about 10% gallium. In another variant, B and O may at least partly be replaced by Si and N. The element A may especially be selected from the group consisting of yttrium (Y), gadolinium (Gd), terbium (Tb) and lutetium (Lu). Further, Gd and/or Tb are especially only present up to an amount of about 20% of A. In a specific embodiment, the garnet luminescent material comprises (Y₁₋ₓLuₓ)₃B₅O₁₂:Ce, wherein x is equal to or larger than 0 and equal to or smaller than 1.

The term ":Ce", indicates that part of the metal ions (i.e. in the garnets: part of the "A" ions) in the luminescent material is replaced by Ce. For instance, in the case of (Y₁₋ₓLuₓ)₃Al₅O₁₂:Ce, part of Y and/or Lu is replaced by Ce. This is known to the person skilled in the art. Ce will replace A in general for not more than 10%; in general, the Ce concentration will be in the range of 0.1 to 4%, especially 0.1 to 2% (relative to A). Assuming 1% Ce and 10% Y, the full correct formula could be (Y_{0.1}Lu_{0.89}Ce_{0.01})₃Al₅O₁₂.

Ce in garnets is substantially or only in the trivalent state, as is known to the person skilled in the art.

In embodiments, a red luminescent material may comprise one or more materials selected from the group consisting of (Ba,Sr,Ca)S:Eu, (Ba,Sr,Ca)AlSiN₃:Eu and (Ba,Sr,Ca)₂Si₅N₈:Eu. In these compounds, europium (Eu) is substantially or only divalent, and replaces one or more of the indicated divalent cations. In general, Eu will not be present in amounts larger than 10% of the cation; its presence will especially be in the range of about 0.5 to 10%, more especially in the range of about 0.5 to 5% relative to the cation(s) it replaces. The term ":Eu", indicates that part of the metal ions is replaced by Eu (in these examples by Eu²⁺). For instance, assuming 2% Eu in CaAlSiN₃:Eu, the correct formula could be (Ca_{0.98}Eu_{0.02})AlSiN₃. Divalent europium will in general replace divalent cations, such as the above divalent alkaline earth cations, especially Ca, Sr or Ba.

The material (Ba,Sr,Ca)S:Eu can also be indicated as MS:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca).

Further, the material (Ba,Sr,Ca)₂Si₅N₈:Eu can also be indicated as M₂Si₅N₈:Eu, wherein M is one or more elements selected from the group consisting of barium (Ba), strontium (Sr) and calcium (Ca); especially, M comprises in this compound Sr and/or Ba. In a further specific embodiment, M consists of Sr and/or Ba (not taking into account the presence of Eu), especially 50 to 100%, more especially 50 to 90% Ba and 50 to 0%, especially 50 to 10% Sr, such as Ba_{1.5}Sr_{0.5}Si₅N₈:Eu (i.e. 75 % Ba; 25% Sr). Here, Eu is introduced and replaces at least part of M, i.e. one or more of Ba, Sr, and Ca).

Likewise, the material (Ba,Sr,Ca)AlSiN₃:Eu can also be indicated as MAlSiN₃:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca).

Eu in the above indicated luminescent materials is substantially or only in the divalent state, as is known to the person skilled in the art.

The term "luminescent material" herein especially relates to inorganic luminescent materials, which are also sometimes indicated as phosphors. These terms are known to the person skilled in the art.

Other luminescent materials than described above are herein not excluded.

Hence, especially the luminescent material is configured to generate luminescent material light upon excitation with light source light from a first laser light source comprising a wavelength λ₁ where the luminescent material can be excited. Hence, the light source that is here used for definition purposes is configured to generate light source light with one or more wavelengths that are excitation wavelength for the luminescent material light of the luminescent material.

The light emitting layer comprises luminescent material. In embodiments, the light emitting layer may exclusively consist of the luminescent material. In other embodiments, the layer may comprise a combination of a light transmissive material and the luminescent material. Herein, the light transmissive material is especially an oxide material.

The light emitting layer is especially a solid material (at standard conditions like 20 °C and atmospheric pressure). The light emitting layer may be a self-supporting layer.

In embodiments, the light emitting layer comprises a ceramic body comprising the luminescent material. Ceramic materials or ceramic bodies are - amongst others - described in WO2019008017 (and references cited therein).

The light emitting layer may in embodiments have a volume of about 0.1-25 cm3. In general, the height of the light emitting layer may be selected from the range of 0.002-2 cm, especially 0.005-1 cm. An equivalent circular diameter may in embodiments be selected from the range of 0.1-5 cm. In embodiments, the light emitting layer may have a square, polygonal (such as hexagonal, octagonal, etc.), or circular cross-section. Especially, the light emitting layer may have a hexagonal or circular cross-section.

The light emitting layer may have a top face and a bottom face. The top face and the bottom face may especially define the height of the light emitting layer. The top face may be directed to the first lens; the bottom face may be directed away from the first lens. Especially, the top face, or at least part thereof, may receive (focused) radiation from the first lens (when the first lens receives radiation to be concentrated). Instead of the term "concentrated" also the term "focused" may be used (in the context of radiation (that propagates to a (concentrator or focusing) lens).

Hence, the light emitting layer comprises a light receiving area. The light receiving area may be the top face (or part thereof). The light receiving area may have a light receiving area size A₁. As can be derived from the above, the light receiving area size may in embodiments be selected from the range of about 0.03-80 cm².

The light receiving area may receive light source light. At least part of the light source light will be converted into luminescent material light. At least part of this luminescent material light may escape form the light emitting layer via the light receiving area. Hence, the light receiving area for receipt of the (focused) light source light may also be a light emitting area of the luminescent material light. Hence, especially the luminescent material is configured in such that the luminescent material light essentially escapes from the luminescent material in the same direction as from which it receives the (focused) (excitation) light source light.

As further indicated above, the first lens comprises a truncated ball shaped lens. Truncated ball lenses are known in the art, and are for instance described in Lee C. Chen, Andy L. Y. Low, and Su F. Chien, Combinational system of a truncated ball lens and a hyperbolic lens for collimating a highly divergent source, APPLIED OPTICS Vol. 43, No. 35 10 December 2004.

Especially, the first lens is configured to concentrate light (especially first light source light) received at the curved lens surface to provide (focused) light (thus especially the first light source light) emanating from the planar lens surface. Especially, the planar lens surface is directed to the light receiving area. As (focused) light is provided to the light receiving area, the light receiving area is especially configured in a light receiving relationship with the planar lens surface. In view of the propagation of light source light from a light source through the first lens, the light receiving area is configured downstream of the planar lens surface.

The terms "upstream" and "downstream" relate to an arrangement of items or features relative to the propagation of the light from a light generating means (here especially the light source), wherein relative to a first position within a beam of light from the light generating means, a second position in the beam of light closer to the light generating means is "upstream", and a third position within the beam of light further away from the light generating means is "downstream".

For light source light propagating from the light source to the light emitting layer, the light receiving area is configured downstream of the planar lens surface. For luminescent material light emanating away from the light emissive layer in a direction of the first lens, in fact the planar lens surface is configured downstream of the light receiving area (here also light emitting area).

Especially, the truncated ball lens may comprise a part sphere. Hence, the truncated ball lens has a curved lens surface having a radius Ro relative to a central point (O). This central point O is especially the center of the sphere with which the curved lens surface shares the curved surface. However, the (imaginary) sphere is truncated. Hence, the truncated ball lens also comprises a planar lens surface configured at a first distance d₁ from the central point (O). It appears that for reduction of spherical aberrations, the first distance d₁ may especially be subject to specific conditions.

The curved lens surface of the first lens is especially defined by the (truncated) ball lens.

The planar lens surface has a planar lens surface area size A₂. In specific embodiments, the planar lens surface area size A₂ is larger than the light receiving area size A₁. This may allow that some parts of the truncated ball lens do not directly receive luminescent material light, also not after the first refraction into the truncated ball lens. Such parts may be used for thermal, or even physical contact with a lens holder and/or thermal conductor. In embodiments, 1<A₂/A₁≤9, especially 1.2≤A₂/A₁≤9, even more especially 1.5≤A₂/A₁≤9.

In embodiments, the lens material comprises one or more of sapphire, MgO, CaF₂, quartz, BaF₂, A₃B₅O₁₂ garnet, ALON, MgAl₂O₄, and MgF₂, Especially, the lens material essentially consists of a single material, for instance especially sapphire. The first lens comprises a lens material having an index of refraction n at a predetermined wavelength λ₁ selected from a wavelength in the UV, visible, and infrared, especially selected from a wavelength in the UV or visible. In specific embodiments, the lens material has an index of refraction n at 589.3 nm selected from the range of 1.4-2.0, especially 1.4-1.9. ALON refers to aluminum oxynitride. It is a ceramic composed of aluminum, oxygen and nitrogen. It is marketed under the name ALON by Surmet Corporation. A chemical composition may be defined as AlN)ₓ·(Al₂O₃)₁₋ₓ, wherein 0.30 ≤ x ≤ 0.37.

A₃B₅O₁₂ garnet refers to systems where A may e.g. be one or more of Y, Lu, Gd, wherein B may be one or more of aluminum or gallium, especially at least aluminum. See also above, for example of systems (but then doped with cerium). Further, A-O may be partly replaced by Si-N, as known in the art.

Especially, n may be taken at a wavelength where the luminescent material is excited with the first light source light from the first light source (when comprised by the system).

As indicated above, the first distance d₁ may especially be subject to specific conditions. Especially, d₁=R₀/n. However, small deviations thereof may also be possible. Hence, in embodiments d₁=x^{∗}R₀/n, wherein 0.9≤x≤1.1, such as 0.95≤x≤1.05.

Further, the system comprises a thermal conductor. Especially, the thermal conductor is configured in thermal contact with one or more of the light emitting layer and the first lens. Note that even though the light emitting layer and/or the first lens may have some thermal conductive properties, the term "thermal conductor" especially refers an element (or elements) other than the light emitting layer and/or the first lens, and will in general also have a higher thermal conductivity than the light emitting layer and or the first lens.

The thermal conductor may comprise a heatsink. The thermal conduction may also comprise a thermally conductive material (such as a thermally conductive glue) in thermal contact with a heatsink.

The term "thermal conductor" may also refer to a plurality of different thermal conductors. For instance, in embodiments the first lens may be in thermal contact with the same thermal conductor as the luminescent material comprising layer or with a different thermal conductor.

An element may be considered in thermal contact with another element if it can exchange energy through the process of heat. In embodiments, thermal contact can be achieved by physical contact. In embodiments, thermal contact may be achieved via a thermally conductive material, such as a thermally conductive glue (or thermally conductive adhesive). Thermal contact may also be achieved between two elements when the two elements are arranged relative to each other at a distance of equal to or less than about 10 µm, though larger distances, such as up to 100 µm may be possible. The shorter the distance, the better the thermal contact. Especially, the distance is 10 µm or less, such as 5 µm or less. The distance may be the distanced between two respective surfaces of the respective elements.

The distance may be an average distance. For instance, the two elements may be in physical contact at one or more, such as a plurality of positions, but at one or more, especially a plurality of other positions, the elements are not in physical contact. For instance, this may be the case when one or both elements have a rough surface (see further also below). Hence, in embodiments in average the distance between the two elements may be 10 µm or less (though larger average distances may be possible, such as up to 100 µm). In embodiments, the two surfaces of the two elements may be kept at a distance with one or more distance holders.

A thermally conductive material may especially have a thermal conductivity of at least about 20 W/m/K, like at least about 30 W/m/K, such as at least about 100 W/m/K, like especially at least about 200 W/m/K.

Heatsinks are known in the art. The term "heatsink" (or heat sink) may especially be a passive heat exchanger that transfers the heat generated by device, such as an electronic device or a mechanical device, to a fluid (cooling) medium, often air or a liquid coolant. Thereby, the heat is (at least partially) dissipated away from the device. A heat sink is especially designed to maximize its surface area in contact with the fluid cooling medium surrounding it. Hence, especially a heatsink may comprise a plurality of fins. For instance, the heatsink may be a body with a plurality of fins extending thereof.

A heatsink especially comprises (more especially consists of) a thermally conductive material. In embodiments, a heatsink may comprise or consist of one or more of copper, aluminum, silver, gold, silicon carbide, aluminum nitride, boron nitride, aluminum silicon carbide, beryllium oxide, a silicon carbide composite, aluminum silicon carbide, a copper tungsten alloy, a copper molybdenum carbide, carbon, diamond, and graphite. Alternatively, or additionally, the heatsink may comprise or consist of aluminum oxide.

The term "heatsink" may also refer to a plurality of (different) heatsinks (which may or which may not be thermally coupled).

A part of the thermal conductor closest to the light emitting layer or a part of the thermal conductor (or another thermal conductor) closest to the first lens may be (specular) reflective for one or more wavelengths in one or more of the UV, visible, and infrared, and especially for one or more wavelengths of the light source light and/or for one or more wavelengths of the luminescent material light.

In order to minimize etendue, it may be desirable to have the light receiving area at some distance from the planar lens surface. In this way, the optical coupling may be reduced. However, for thermal contact purposes, the distance is especially not too large. Hence, in embodiments the light receiving area is configured at second distance d₂ selected from the range of 1-10 µm from the planar lens surface. As can be derived from the above, (also) this distance may be an average distance. Hence, in further specific embodiments the light receiving area is configured at an average second distance d₂ₐ selected from the range of 1-10 µm from the planar lens surface. Distance holders and/or surface roughness may be used to create such (average) second distance (see also above). In embodiments, the area roughness Sa (arithmetic mean height) may be selected from the range of about 1-10 µm, such as in the range of about 1-5 µm.

In other embodiments, however, the light receiving area is configured at an average second distance d₂ₐ selected from the range of < 1 µm from the planar lens surface. For instance, the light receiving area and the planar lens surface are essentially in physical contact (over a substantial part of the area of the light receiving area). Thermal contact between the first lens and light emitting layer may be better, but etendue may increase.

The first lens is (amongst others) defined by its external surface. The first lens especially has an external surface comprising the curved lens surface and the planar lens surface. When luminescent material light enters the first lens (via refraction), a subset of the thus entered rays of luminescent material light may reach all parts of the external surface of the lens directly, but e.g. only after one or multiple internal reflection. Amongst others, this may be due to the fact that the planar lens surface area size A₂ is larger than the light receiving area size A₁ (of the light receiving area).

Hence, in embodiments the first lens has an external surface comprising the curved lens surface and the planar lens surface, wherein the first lens is configured such that rays of luminescent material light entering the first lens via the planar lens surface cannot directly reach a first external surface part of the external surface, wherein the thermal conductor is in thermal contact with the first lens via the first external surface part.

The term "first external surface part" may refer to an optically less active part or optically inactive part. The first external surface part may in embodiments have some overlap with the planar lens surface (due to the fact that the planar lens surface area size A₂ is larger than the light receiving area size A₁). Alternatively or additionally, the first external surface part may in embodiments have some overlap with the curved lens surface. In other embodiments, however, the first external surface part has essentially no overlap with the curved lens surface (i.e. they are different parts of the external surface). The term "first external surface part" may also refer to a plurality of such parts. An advantage may be that the cooling of the first lens is improved.

The ball shaped lens may be truncated at different positions. Dependent thereon, and dependent on the index of refraction, in order to achieve the first distance to the planar lens surface, there may be also a cylindrical part of the lens.

Hence, in embodiments the lens may have a hemisphere shape. In other embodiments the lens may have the shape of a combination of a hemisphere and a cylinder (ball elongated in a single direction and truncated). Therefore, in specific embodiments the first lens may comprise a ball part comprising the curved lens surface and a cylindrical part comprising the planar lens surface, wherein the cylindrical part has cylindrical shape or a tapered cylindrical shape.

At the edge of the truncated ball (closest to the planar lens surface) or at the edge of the cylinder, the thermal conductor may be in thermal contact, such as in physical contact, with the first lens. In this way, possible optical contact (like physical contact) with the first lens may be minimized.

In embodiments, the edge of the truncated ball may comprise a tapering (tapering in the direction of the planar lens surface). In yet other embodiments, the edge of the cylinder may comprise a tapering (tapering in the direction of the planar lens surface). At the tapering of the truncated ball or at the tapering of the cylinder, the thermal conductor may be in thermal contact, such as in physical contact, with the first lens. In this way, possible optical contact (like physical contact) with (the curve lens surface (and/or the planar lens surface) of) the lens may be minimized.

Hence, in specific embodiments the first lens may comprise a ball part comprising the curved lens surface and a cylindrical part comprising the planar lens surface, wherein the cylindrical part has cylindrical shape or a tapered cylindrical shape, wherein the thermal conductor is in thermal contact with the cylindrical part but not in physical contact with the planar lens surface.

It may (thus) also be desirable that heat is dissipated away from the light emitting layer. Heat may be dissipated via the first lens. Alternatively or additionally, heat may be dissipated via the thermal conductor. Therefore, in embodiments the light emitting layer is in thermal contact with the thermal conductor. Especially, however, the light emitting layer is not in thermal contact and also not in optical with the thermal conductor. Hence, especially the bottom face of the light emitting layer and/or a side face of the light emitting layer, may be in thermal contact with the thermal conductor. Therefore, in specific embodiments the light emitting layer may comprise a non-light receiving face (such as the bottom face and/or a side face of the light emitting layer), wherein the non-light receiving face is not configured in a light receiving relationship with the first lens, wherein the thermal conductor is in thermal contact, especially in physical contact with at least part of the non-light receiving face of the light emitting layer.

As indicated above, the system described herein does not necessarily comprise a light source. However, in specific embodiments the system comprises a light source. In such embodiments, the system may also be indicated as "lighting system". The light source may also be indicated as pump light source.

The system further comprises the first laser light source configured to generate the first light source light, wherein the curved lens surface is configured in a light receiving relationship with the first laser light source. Hence, seen from the first light source, the curved lens surface is configured downstream of the first light source; the planar lens surface is in average configured even further downstream of the first light source.

The term "light source" may refer to a semiconductor light-emitting device, such as a light emitting diode (LEDs), a resonant cavity light emitting diode (RCLED), a vertical cavity laser diode (VCSELs), an edge emitting laser, etc... The term "light source" may also refer to an organic light-emitting diode, such as a passive-matrix (PMOLED) or an active-matrix (AMOLED). In a specific embodiment, the light source comprises a solid state light source (such as a LED or laser diode). In an embodiment, the light source comprises a LED (light emitting diode). The term LED may also refer to a plurality of LEDs. Further, the term "light source" may in embodiments also refer to a so-called chips-on-board (COB) light source. The term "COB" especially refers to LED chips in the form of a semiconductor chip that is neither encased nor connected but directly mounted onto a substrate, such as a PCB. Hence, a plurality of semiconductor light sources may be configured on the same substrate. In embodiments, a COB is a multi LED chip configured together as a single lighting module. The term "light source" may also relate to a plurality of (essentially identical (or different)) light sources, such as 2-2000 solid state light sources. In embodiments, the light source may comprise one or more micro-optical elements (array of micro lenses) downstream of a single solid state light source, such as a LED, or downstream of a plurality of solid state light sources (i.e. e.g. shared by multiple LEDs). In embodiments, the light source may comprise a LED with on-chip optics. In embodiments, the light source comprises a pixelated single LEDs (with or without optics) (offering in embodiments on-chip beam steering).

The phrases "different light sources" or "a plurality of different light sources", and similar phrases, may in embodiments refer to a plurality of solid state light sources selected from at least two different bins. Likewise, the phrases "identical light sources" or "a plurality of same light sources", and similar phrases, may in embodiments refer to a plurality of solid state light sources selected from the same bin.

Herein, the term "light source" especially refers to a substantially monochromatic light source, such as a full width half maximum (FWHM) of the light source light of equal to or less than 50 nm, like equal to or less than 40 nm. The term light source may especially refer to a solid state based light source, such as a LED laser or LED. In specific embodiments, a concentrator type of light source may be applied, based on a rod in which light source light of a plurality of (solid state) light sources is coupled. Light escaping from the nose of such rod may be used as the light source light (to pump the luminescent material). Therefore, in specific embodiments the first light source comprises plurality of solid state light sources which together are configured to generate the first light source light.

The first light source is especially configured to generate first light source light comprising a wavelength where the luminescent material can be excited. Hence, the first light source light can be used to excite the luminescent material. The term "first light source light comprising a wavelength where the luminescent material can be excited" especially indicated that the first light source light has a spectral power distribution with (substantial) intensity at a wavelength where the luminescent material can be excited. The term "a wavelength" may also refer to a one or more (different) wavelengths, such as plurality of different wavelengths. The first light source may in embodiments be configured to generate one or more of UV and blue radiation, such as at least blue radiation. As indicated above, one of these one or more wavelengths may also be used as reference wavelength for the index of refraction. This wavelength may e.g. be a peak wavelength of the first light source (light).

In embodiments, the system may further comprise a second lens configured upstream from the first lens as seen from the first light source, with a function that depends on the rest of the optical system. This second lens can for instance be a condenser lens, especially to make the light emerging from the truncated lens more parallel. Or such second lens can be a projection lens, especially for focusing the light onto some distant plane.

As the first light source light may partially be reflected by the light emission layer, this first light source light may be admixed with the luminescent material light. Hence, light ("system light" or "lighting system light") emanating from the system comprises luminescent material light and optionally first light source light. In embodiments, this may be white light, though in other embodiments this may be colored light. As indicated above, the luminescent material light is not necessarily visible light. However, especially the luminescent material light comprises visible light.

Alternatively or additionally, a second light source may be applied, configured to generate second light source light. Together with luminescent material light and the optional first light source light, this may in embodiments be white light. Of course, in other embodiments, this may be visible light. This may amongst others also depend upon the intensity ratios of the luminescent material light and the second light source light. As in embodiments the second light source and the first light source may individually be controlled, one or more of the color point, color temperature, and color rendering index of the (visible) system light may be controlled.

Hence, in embodiments the system may also comprise a control system, configured to control the system light (by controlling the first light source and optionally other light sources). The first light source and the optionally other light sources may e.g. be controlled with respect to the intensity (power in Watt) of the light source light that is generated by the respective light source.

The system is configured to generate lighting system light, wherein the lighting system light comprises the luminescent material light. The system may further comprises a second light source configured to generate second light source light having a spectral power distribution different from or equal to the first light source light and different from the luminescent material light, wherein in an operation mode of the system the lighting system light further comprises the second light source light. Hence, the second light source may in embodiments have the same spectral power distribution as the first light source. However, the arrangement of the first light source and the second light source are different, as the former is configured to excite the luminescent material, and the latter is used to optionally add second light source light to the luminescent material light, without essentially having the second light source providing the second light source light to the luminescent material. The second light source light may propagate through the system without essentially reaching the luminescent material.

As indicated above, in embodiments the system may be configured to provide in an operation mode white system light. The white system light may comprise the luminescent material light, optionally (unconverted) first light source light, and optionally second light source light.

The term "white light" herein, is known to the person skilled in the art. It especially relates to light having a correlated color temperature (CCT) between about 1800 K and 20000 K, such as between 2000 and 20000 K, especially 2700-20000 K, for general lighting especially in the range of about 2700 K and 6500 K. In embodiments, for backlighting purposes the correlated color temperature (CCT) may especially be in the range of about 7000 K and 20000 K. Yet further, in embodiments the correlated color temperature (CCT) is especially within about 15 SDCM (standard deviation of color matching) from the BBL (black body locus), especially within about 10 SDCM from the BBL, even more especially within about 5 SDCM from the BBL.

The terms "visible", "visible light" or "visible emission" and similar terms refer to light having one or more wavelengths in the range of about 380-780 nm.

The term "controlling" and similar terms especially refer at least to determining the behavior or supervising the running of an element. Hence, herein "controlling" and similar terms may e.g. refer to imposing behavior to the element (determining the behavior or supervising the running of an element), etc., such as e.g. measuring, displaying, actuating, opening, shifting, changing temperature, etc... Beyond that, the term "controlling" and similar terms may additionally include monitoring. Hence, the term "controlling" and similar terms may include imposing behavior on an element and also imposing behavior on an element and monitoring the element. The controlling of the element can be done with a control system, which may also be indicated as "controller". The control system and the element may thus at least temporarily, or permanently, functionally be coupled. The element may comprise the control system. In embodiments, the control system and element may not be physically coupled. Control can be done via wired and/or wireless control. The term "control system" may also refer to a plurality of different control systems, which especially are functionally coupled, and of which e.g. one control system may be a master control system and one or more others may be slave control systems. A control system may comprise or may be functionally coupled to a user interface.

The control system of (or for) the system may be configured to be controlled by an external control system which has access to the system on the basis of knowledge (input by a user interface of with an optical sensor (e.g. QR code reader) of the (unique) code. The system may also comprise means for communicating with other systems or devices, such as on the basis of Bluetooth, Wi-Fi, ZigBee, BLE or WiMAX, or another wireless technology.

The system, or apparatus, or device may execute an action in a "mode" or "operation mode" or "mode of operation". Likewise, in a method an action or stage, or step may be executed in a "mode" or "operation mode" or "mode of operation". The term "mode" may also be indicated as "controlling mode". This does not exclude that the system, or apparatus, or device may also be adapted for providing another controlling mode, or a plurality of other controlling modes. Likewise, this may not exclude that before executing the mode and/or after executing the mode one or more other modes may be executed.

However, in embodiments a control system may be available, that is adapted to provide at least the controlling mode. Would other modes be available, the choice of such modes may especially be executed via a user interface, though other options, like executing a mode in dependence of a sensor signal or a (time) scheme, may also be possible. The operation mode may in embodiments also refer to a system, or apparatus, or device, that can only operate in a single operation mode (i.e. "on", without further tunability).

Hence, in embodiments, the control system may control in dependence of one or more of an input signal of a user interface, a sensor signal (of a sensor), and a timer. The term "timer" may refer to a clock and/or a predetermined time scheme.

The terms "second light source" and "second light source light" and similar terms may especially refer to any additional light source that is not used to irradiate the light emitting layer, but which light source light may optionally be used to be mixed with the luminescent material light in the system light. Hence, the term second light source may also refer to a plurality of (subsets of) second light sources which are configured to generate second light source light having different spectral power distributions.

As in embodiments the luminescent material light and the light source light may have essentially the same optical path, it may be desirable to redirect the luminescent material light after the luminescent material light has propagated through the first lens (and optional further lenses through which also the light source light propagates on its way to the light emitting layer; see also below). Hence, beam splitter optics, especially dichroic beam splitter optics may be applied. Such beam splitter optics may comprise one or more dichroic filters, as known in the art. The beam splitter optics may especially be configured to allow the light source light to pass the beam splitter optics without essential redirection and allow the luminescent material light source light pass the beam splitter optics with essential redirection.

Therefore, in embodiments the system may further comprise beam splitter optics, wherein the first light source is configured to provide the first light source light along a first optical path in a first direction via the beam splitter optics to the curved lens surface of the first lens, and wherein the beam splitter optics are configured to direct luminescent material light received by the beam splitter optics along a second optical path not coinciding with the first optical path in a second direction.

As indicated above, a second light source may be available. In such embodiments, the second light source may provide light source light in the direction of the beam splitter optics, parallel to the second direction of the luminescent material light, with essentially coinciding respective optical axes (downstream from the beam splitter optics. In this way, the luminescent material light and second light source light may be combined in a single light beam. Hence, in embodiments the second light source is configured to provide the second light source light along a third optical path via the dichroic beam splitter optics in the second direction.

In yet a further aspect, the invention also provides a lighting device comprising (i) the lighting system as defined herein and (ii) optionally further optics for shaping and/or modifying the system light.

The lighting device or lighting system may be part of or may be applied in e.g. office lighting systems, household application systems, shop lighting systems, home lighting systems, accent lighting systems, spot lighting systems, theater lighting systems, fiber-optics application systems, projection systems, self-lit display systems, pixelated display systems, segmented display systems, warning sign systems, medical lighting application systems, indicator sign systems, decorative lighting systems, portable systems, automotive applications, (outdoor) road lighting systems, urban lighting systems, green house lighting systems, horticulture lighting, or LCD backlighting.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figs. 1a-1d schematically depict some aspects and embodiments of the system and the first lens;
Figs. 2a-2c schematically depict some embodiments and aspects, also in relation to an alternative solution (see Fig. 2b); and
Figs. 3a-3e schematically depict some further embodiments (and aspects).

The schematic drawings are not necessarily to scale.

### DETAILED DESCRIPTION OF THE EMBODIMENTS

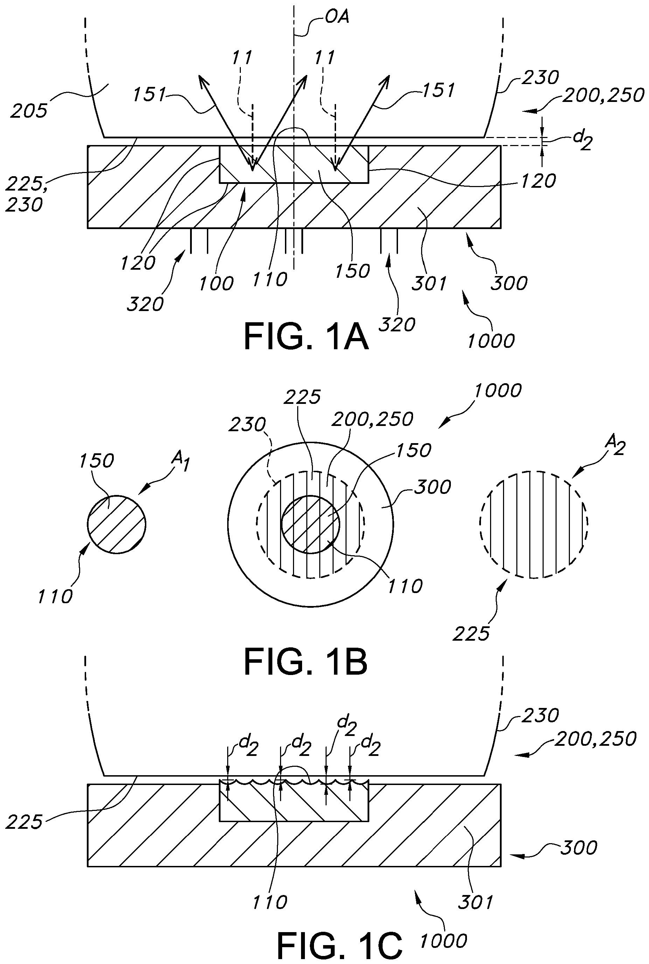

Fig. 1a schematically depicts a system 1000 comprising (i) a light emitting layer 100, (ii) a first lens 200, and a thermal conductor 300. More precisely, part of the system is shown, as the lens is not fully depicted.

The light emitting layer 100 comprises luminescent material 150, wherein the luminescent material 150 is configured to generate luminescent material light 151 upon excitation with light source light 11 from a first light source (not shown), wherein the light source light comprises a wavelength where the luminescent material 150 can be excited. The light emitting layer 100 is embedded in a support but could also be provided on a support.

Here, the support is indicated with reference 300, as the support can have the function of a thermal conductor. The thermal conductor 300 is configured in thermal contact with one or more of the light emitting layer 100 and the first lens 200; here with essentially only the light emitting layer 100. The thermal conductor may include one or more fins 320, especially a plurality of fins 320. The thermal conductor comprises a thermally conductive material 301. The thermal conductor 300 may especially comprises a heat sink.

The light emitting layer 100 comprises a light receiving area 110 having a light receiving area size A₁.

The first lens 200 comprises a truncated ball shaped lens 250. The first lens comprises a planar lens surface 225. The planar lens surface 225 is directed to the light receiving area 110. The planar lens surface 225 has a planar lens surface area size A₂.

As schematically depicted, the planar lens surface area size A₂ is larger than the light receiving area size A₁ (see also Fig. 1b). The light receiving area 110 is configured at a second distance d₂ selected from the range of 1-10 µm from the planar lens surface 225 (see further also Fig. 1c), though the light receiving area 110 and the planar lens surface 225 may also essentially have a zero distance over the overlapping areas.

The first lens 200 comprises a lens material 205 having an index of refraction n at a predetermined wavelength λ₁ selected from a wavelength in the UV, visible, and infrared. The lens material 205 may e.g. comprises one or more of sapphire, MgO, CaF₂, quartz, BaF₂, A₃B₅O₁₂ garnet (A e.g. one or more of Y, Gd, and Lu; B e.g. one or more of Al and Ga, especially at least or essentially only AI), ALON, MgAl₂O₄, and MgF₂. For instance, in embodiments the lens material 205 may be sapphire.

Reference 230 indicates the external surface of the first lens. The external surface of the lens comprises amongst others the planar lens surface 225.

The light emitting layer 100 comprises a non-light receiving face 120, wherein the non-light receiving face 120 is not configured in a light receiving relationship with the first lens 200, wherein the thermal conductor 300 is in thermal contact, especially in physical contact with at least part of the non-light receiving face 120 of the light emitting layer 100. The non-light receiving face 120 may e.g. comprise an edge face and/or a bottom face.

Fig. 1a schematically depicts a cross-section, e.g. with the cross-sectional plane parallel to an optical axis OA of the first lens 200. Fig. 1b schematically depicts a cross-section perpendicular to the cross-section of Fig. 1a. Assuming a circular support and a circular light emitting layer 100, the two solid circles in the middle indicate these respectively, with the smaller solid circle indicating the light receiving area 110, with area size A₁ (see detail on the left), and the larger solid circle indicating the support, which is here an embodiment of the thermal conductor 300. The dashed circle in the middle, is in fact not in the same plane, as the dashed circle indicates the planar lens surface 225 of the first lens, having a planar lens surface area A₂ (see detail on the right). The planar lens surface area size A₂ is especially larger than the light receiving area size A₁. For instance, 1.2≤A₂/A₁≤9.

The planar lens surface 225 and the light emitting layer 100 may be configured at a second distance d₂ from each other, may essentially entirely be in physical contact, or may have parts that have physical contact and parts that do not have physical contact. The latter embodiment may e.g. be achieved when one of the phases has some surface roughness. Here, by way of example, the light emitting layer 100, such as a ceramic body, has surface roughness. Therefore, the light receiving area 110 may be configured at an average second distance d₂ₐ selected from the range of 1-10 µm from the planar lens surface 225. As indicated above, however, the average distance may also be smaller: the light receiving area 110 may be configured at an average second distance d₂ₐ selected from the range of < 1 µm from the planar lens surface 225.

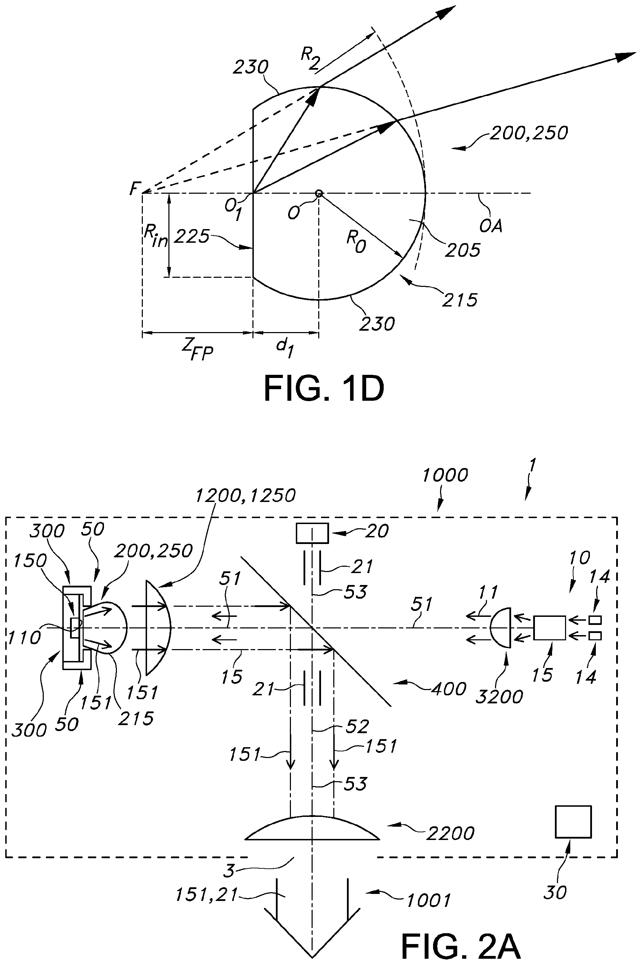

Fig. 1d schematically depicts an embodiment of the truncated ball lens 250 as embodiment of the first lens 200. Here, R₀ is the radius of the ball, and n is the index of refraction. Reference O indicates the center of the virtually non truncated ball, and is at a distance Ro of a curved lens surface 215 (i.e. the remaining part of the ball). Reference O₁ indicates the center of the plan lens surface 225, which is configured at first distance d₁ from the center O. Distance d₁ is defined as d₁=R₀/n. However, there may be some deviation therefrom.

Hence, the first lens 200 comprises a truncated ball shaped lens 250 having a curved lens surface 215 having a radius Ro relative to a central point O, and a planar lens surface 225 configured at a first distance d₁ from the central point O, wherein, wherein d₁=x^{∗}R₀/n, wherein 0.9≤x≤1.1

The focal length of the ball is indicated as R₂ and is defined as R₂=(n+1)^{∗}R₀.

The focal point of the ball is indicated as z_{FP} and is defined as z_{FP} =d+R₀-R₂.

The radius entrance Rᵢₙ is defined as Rᵢₙ=R₀/n^{∗}(SQRT(n²-1)).

Reference 230 indicates the external surface of the first lens, which comprises the planar lens surface 225 and the curved lens surface 215.

Reference OA indicates an optical axis (here of the first lens 200).

Fig. 2a schematically depicts an embodiments of the system 1000, wherein the system is also a lighting system, and wherein the (lighting) system 1000 is configured to generate lighting system light.

As schematically depicted, the first lens 200 is configured to concentrate first light source light 11 received at the curved lens surface 215 to provide (focused) first light source light 11 emanating from the planar lens surface 225, to the light receiving area 110 of the light emitting layer 100.

Fig. 2a therefor schematically depicts an embodiment and variants of the system 1000 comprising the light emitting layer 100, the first lens 200, and the thermal conductor 300.

The light emitting layer 100 comprises luminescent material 150, wherein the luminescent material 150 is configured to generate luminescent material light 151 upon excitation with light source light 11 from the first light source 10 comprising a wavelength where the luminescent material 150 can be excited. The light emitting layer 100 comprises the light receiving area 110 having a light receiving area size A₁. The first lens 200 comprises the truncated ball shaped lens 250 having the curved lens surface 215 and the planar lens surface 225 as defined above. The planar lens surface 225 has a planar lens surface area size A₂. The first lens 200 is configured to concentrate light received at the curved lens surface 215 to provide (focused) light emanating from the planar lens surface 225. As schematically shown, the planar lens surface 225 is directed to the light receiving area 110.

Especially, the system 1000 may be configured to generate lighting system light 1001, wherein the lighting system light 1001 comprises the luminescent material light 151.

The thermal conductor 300 is configured in thermal contact with one or more of the light emitting layer 100 and the first lens 200. Here, the thermal conductor in in thermal contact, or even in physical contact, with both the light emitting layer 100 and the first lens 200, see lens holder(s) 50.

Hence, the embodiment of the system 1000 schematically depicted in Fig. 2a further comprises the first light source 10 configured to generate the first light source light 11. As schematically depicted, the curved lens surface 215 is configured in a light receiving relationship with the first light source 10.

In embodiments, the first light source 10 comprises plurality of solid state light sources 14, such as lasers, which together are configured to generate the first light source light 11. A (fourth) beam shaping element 3200 may be used to shape the light source light 11 in the right beam shape. Reference 15 indicates a concentrator, which is here an elongated rod at which nose the light of the plurality of light source escapes as concentrated beam of the light of the plurality of solid state light sources 14, such as lasers.

In embodiments of the system 1000, the system may further comprise a second lens 1200, comprising an aspherical condenser lens 1250, configured upstream from the first lens 200 as seen from the first light source 10. Further, the system 1000 may in embodiments further comprise a third lens 2200 for further beam shaping of the lighting system light 1001, such as downstream of the beam splitter optics 400 (see further below). The third lens 2200 may be a relay lens to create a focus further on the optical system or a projection lens to focus on a screen far away.

In embodiments of the system 1000, the system 1000 may further comprise dichroic beam splitter optics 400. In such embodiments, the first light source 10 may (thus) be configured to provide the first light source light 11 of a first wavelength along a first optical path 51 in a first direction via the dichroic beam splitter optics 400 to the curved lens surface 215 of the first lens 200, and the dichroic beam splitter optics 400 may be configured to direct luminescent material light 151 of a second wavelength received by the beam splitter optics 400 along a second optical path 52 not coinciding with the first optical path 51 in a second direction. The second wavelength may be identical to the first wavelength.

Essentially all first light source light 11 may be converted and absorbed by the luminescent material 150. Hence, it may be desirable to add further light to the system light 1001 in addition to the luminescent material light 151. In this way, e.g. the color point of visible light may be tuned, and the color rendering index of visible light may be improved. In case of controllable light sources, such as with control system 30, the spectral properties of the system light 1001 may also be controlled.

Hence, in embodiments the system 1000 may further comprise a second light source 20 configured to generate second light source light 21 having a spectral power distribution equal to or different from the first light source light 11 and different from the luminescent material light 151. In an operation mode of the system 1000 the system light 1001 further comprises the second light source light 21. Hence, in an operation mode, the control system may impose on the system that the system light 1001 further comprises the second light source light 21. In a specific embodiment, the system 1000 is configured to provide in an operation mode white system light 1001. In such embodiments, the luminescent material 150 and the optional second light source 20 are configured to generate visible luminescent material light 151 and visible second light source light 21, respectively.

As schematically depicted in the embodiment of the system of Fig. 2a, the second light source 20 may be configured to provide the second light source light 210 along a third optical path 53 via the beam splitter optics 400 in the second direction. This third optical path may coincide with the second optical path downstream of the beam splitter optics 400.

Fig. 2a also shows an embodiment and variants a lighting device 1 comprising (i) the lighting system 1000 according to any one of the preceding claims and (ii) optionally further optics for shaping and/or modifying the system light 1001. The dashed line surrounding the elements of the system 1000 may e.g. be considered a housing of the lighting device 1. Reference 3 indicates an opening in the housing for escape of the lighting system light 1001 to the external of the device 1 (or system 1000).

A possible architecture for e.g. a laser-based lighting system (for instance for GOBO ("goes before optics" or "goes between optics") applications), with a reflective phosphor may comprise a pump laser, a lens, a dichroic beam splitter 1, and a ceramic phosphor. For instance, light from one or more blue pump lasers may be mixed in a mix rod and collimated with a lens. After passing a dichroic beam splitter the pump light is focused onto the ceramic phosphor with e.g. a tandem of condenser lenses. The converted light is collected by the same condenser lenses and directed by the dichroic mirror towards the exit of the lighting system.

It appears, however, that lenses are not perfectly transparent and may absorb a little light. The power density of the blue pump light inside the second (smaller) condenser lens can be so high that fracture occurs due to thermally induced stresses and the limited thermal conductivity of the lens. Hence, thermally induced stresses in the condenser lens may occur which may lead to damage, fracture, or even explosion of the lens. Further, it also appears that the image quality of the converted light beam at a Gobo of the lighting system may not be sufficiently high due to spherical aberrations in the condenser lenses. Further, high quality aspherical condenser lenses may be relatively expensive.

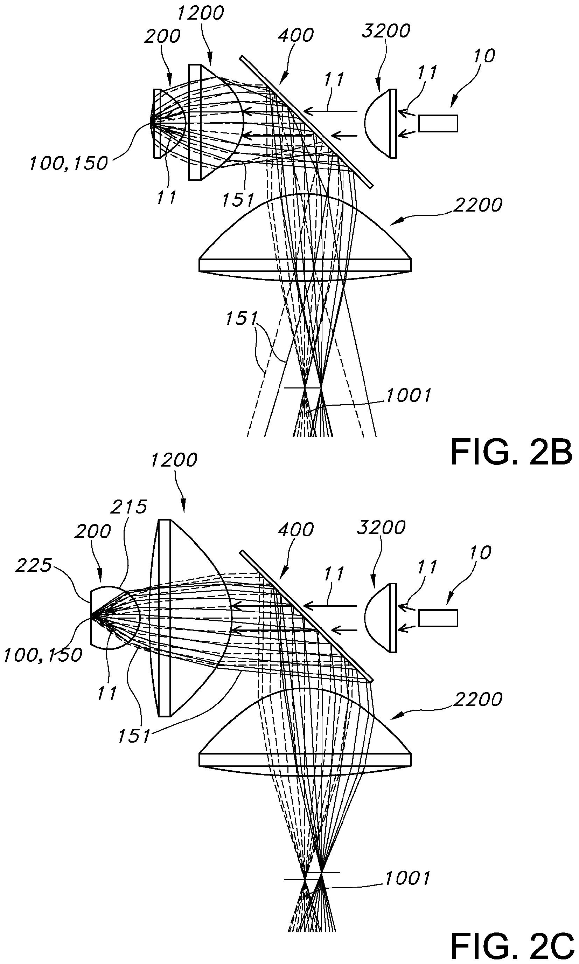

Referring to Figs. 2b and 2c, by using a condenser lens e.g. from sapphire an improved thermal management may be accomplished because of higher thermal conductivity of sapphire (~34W/mK versus ~1W/mK for glass) and less optical absorption. By applying a truncated ball lens as the second condenser lens a system without spherical aberration may be accomplished, for instance resulting in a better spot quality at the Gobo gate. The manufacturing of a truncated ball lens may be less complex than that of a high-quality aspherical lens. This may also improve reliability.

Referring to Fig. 2b, in an alternative solution, two condenser lenses may be applied. This combination of optics in Fig. 2b may lead to a relatively large aberration.

Referring to Fig. 2c (see also Fig. 2a), the second (small) condenser lens (from Fig. 2b) is replaced by a truncated ball lens made from sapphire (or other material listed herein). Especially, the ball lens is truncated at a position d = Ro/n, where Ro is the radius and n the refractive index of the ball. Such solution may essentially have no spherical aberration.

The (air) gap between phosphor and lens may be relatively small, such as 1-10 µm. A smaller air gap favors an improved heat flow from the phosphor through the lens towards the sides. As can be seen from the figures there is ample room to mount the ball lens onto a further heat sink (not shown): the light only passes through the center part of the ball lens and not through the rim.

Optionally the shape of the ball lens can be adapted to improve heat conduction by shortening the path to the heat sink and to improve the contact area with the heat sink, as detailed in the following embodiments.

With the thermal conductivity of sapphire of 34.6 W/mK the estimate of thermal resistance of a 10 mm² area and a typical sapphire thickness dS are R_th = 3 dS [K/W], so for a 10 mm typical distance the resistance would be 30 K/W. Reducing the distance dS to a few mms is thus much worthwhile.

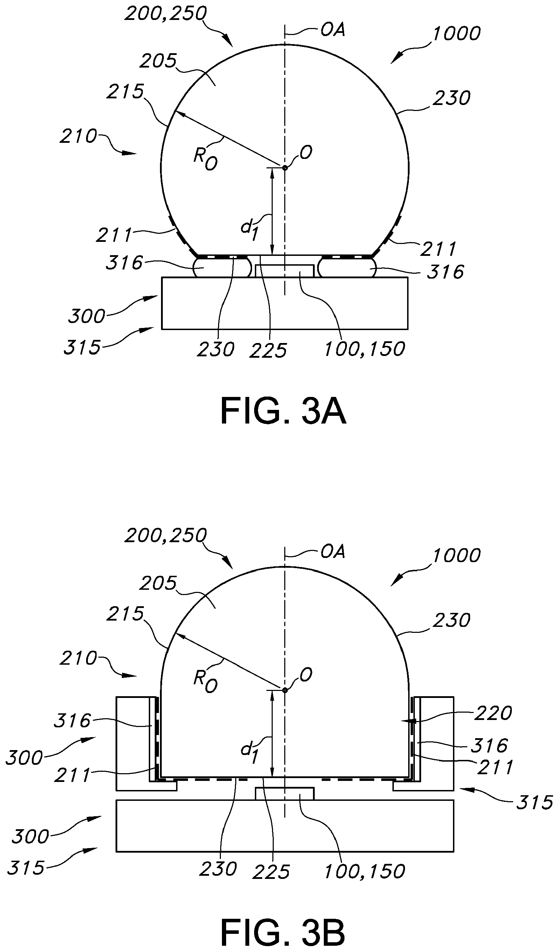

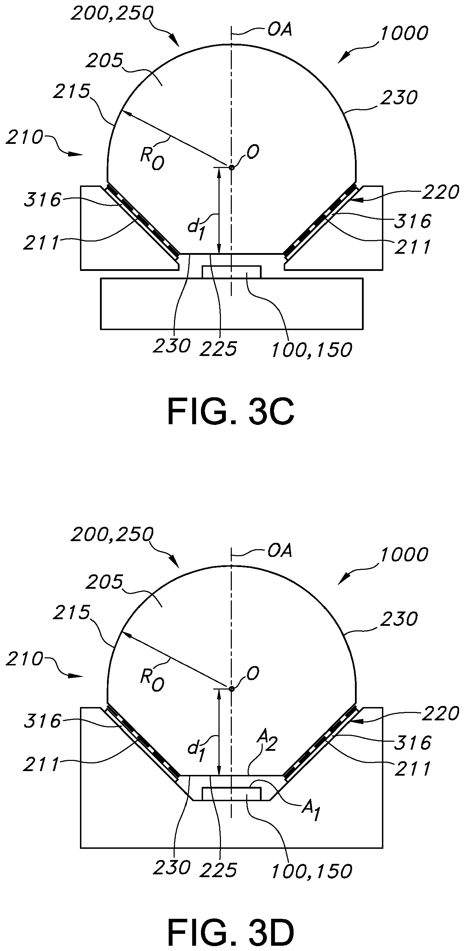

Optionally the truncated side of the ball lens in the area around the converter element is mounted in thermal contact with a heat sink, which is enabled by the fact that this surface is optically inactive. In this way a very short thermal path is realized with the minimum possible thermal resistance. Various thermal interface materials could be used, such as preferably phase change materials. A schematic drawing (cross section) is shown in Fig. 3a.

Fig. 3a schematically depicts an embodiment of thermo-mechanical interfacing of the truncated ball lens around the converter towards the heat sink.

It may be preferable to have the thermal and mechanical function integrated, as shown in Fig. 3a, but it is possible as well to separate these two functions and realize the mechanical alignment independently.

Reference 300 refers to the thermal conductor, which may comprise a heatsink 315. Further, the thermal conductor may also comprise thermally conductive intermediate material, such as a thermally conductive glue. The intermediate material for thermal coupling is indicated with reference 316.

Referring to Figs. 3b-3e, the first lens 200 may comprise a ball part 210 comprising the curved lens surface 215, and a cylindrical part 220 comprising the planar lens surface 225, wherein the cylindrical part 220 has cylindrical shape or a tapered cylindrical shape, wherein the thermal conductor 300 is in thermal contact with the cylindrical part 220 but not in physical contact with the planar lens surface 225.

Optionally the shape of the ball lens is adapted in the optically non-active areas to enable suitable mounting and good thermal contact to transfer the heat generated inside the lens due to the absorption of light in the lens. One configuration is the combination of a half-sphere with a cylindrical part. This is depicted schematically in Fig. 3b. Fig. 3b schematically depicts a schematic cross section of a modified ball lens comprising a cylindrical section and a half-spherical section, enabling convenient mounting, alignment, and cooling of the lens. The embodiment of 3b of the truncated ball shaped lens may be a kind of ball elongated in a single direction (here downwards) and truncated. The longer the elongation, the longer d₁ may be.

Optically non-active areas are indicated with the dashed lines and with reference 211. Hence, the first lens 200 has an external surface 230 comprising the curved lens surface 215 and the planar lens surface 225, wherein the first lens 200 is configured such that rays of luminescent material light 151 entering the first lens 200 via the planar lens surface 225 cannot directly reach a first external surface part 211 of the external surface 230, wherein the thermal conductor 300 is in thermal contact with the first lens 200 via the first external surface part 211. The first external surface part 211 may thus also be indicated as optically inactive or non-active areas. Note that in general the first external surface part 211 will be different from the curved lens surface 215 but may partially overlap with the planar lens surface 225. However, the first external surface part 211 may also not overlap with either of these; for instance, in embodiments the external surface 230 may be defined by essentially the curved lens surface 215, the planar lens surface 225, and the first external surface part 211 (or the optically non-active areas).

Another configuration is the combination of a spherical part and a conical part. The latter has the advantage of a further reduction of the thermal path and therefore reduction of the thermal resistance. See Figs. 3c-3d for a schematic picture of these embodiments. Figs. 3c-3d schematically depict various modified truncated ball lens shapes and mounting options. (3c): cone-shaped part in the optically inactive region of the ball lens for accurate mounting in a heat sink for the lens using a mechanical and thermal interconnect material enabling independent cooling from the converter; (3d): integrated version of the version as depicted in (3c). Version (3c) as shown in the figure enables independent cooling of the ball lens from the luminescent converter, as well as accurate and independent alignment. Version (3d) offers a very simple mounting and alignment of the ball lens relative to the luminescent converter.

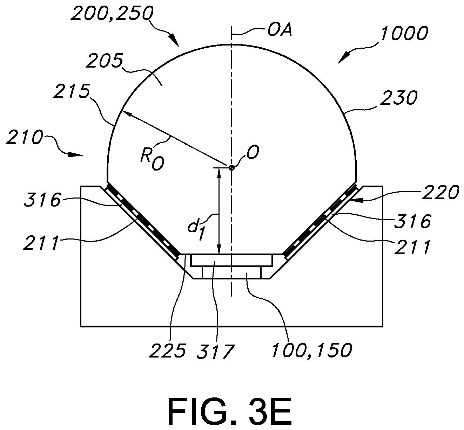

Optionally the truncated ball lens is mounted in optical contact with the luminescent converter. This has the advantage of a somewhat enhanced coupling of blue light into the converter and a significantly enhanced light extraction from the converter, resulting in reduced thermal dissipation in the converter and thereby enabling an increased system efficiency, albeit at the cost of some etendue increase. An embodiment with this configuration is shown in Fig. 3e. Fig. 3e schematically depicts an embodiment of an integrated opto-thermo-mechanical mounting of a truncated ball shaped condenser lens with conical thermo-mechanical mounting section and direct optical interconnection between the truncated part of the ball lens and the luminescent converter by an optically transparent interconnect material 317.

A suitable optical material for this interconnect would be an optical silicone material that shows very low absorption in the typically (deep-) blue wavelength range of the pump laser. The conical section should be sufficiently small in this case to limit the optical losses that will arise in that area, as the light rays in the ball lens will spread over a significantly wider angular range (depending on the relative refractive indices of the lens and the optical interconnect).

Amongst others, the invention is applicable in particular for laser-pumped light sources, but optionally as well for high brightness (HB) LED-pumped light sources with a remote luminescent converter. Application areas are all areas where high brightness sources are requested, such as high flux / narrow beam spot lighting, entertainment/studio/stage lighting, and projection, etc.

The term "plurality" refers to two or more.

The terms "substantially" or "essentially" herein, and similar terms, will be understood by the person skilled in the art. The terms "substantially" or "essentially" may also include embodiments with "entirely", "completely", "all", etc. Hence, in embodiments the adjective substantially or essentially may also be removed. Where applicable, the term "substantially" or the term "essentially" may also relate to 90% or higher, such as 95% or higher, especially 99% or higher, even more especially 99.5% or higher, including 100%.

The term "comprise" includes also embodiments wherein the term "comprises" means "consists of'.

The term "and/or" especially relates to one or more of the items mentioned before and after "and/or". For instance, a phrase "item 1 and/or item 2" and similar phrases may relate to one or more of item 1 and item 2. The term "comprising" may in an embodiment refer to "consisting of" but may in another embodiment also refer to "containing at least the defined species and optionally one or more other species".

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

The devices, apparatus, or systems may herein amongst others be described during operation. As will be clear to the person skilled in the art, the invention is not limited to methods of operation, or devices, apparatus, or systems in operation.

It should be noted that the above-mentioned embodiments illustrate rather than limit the invention, and that those skilled in the art will be able to design many alternative embodiments without departing from the scope of the appended claims.

In the claims, any reference signs placed between parentheses shall not be construed as limiting the claim.

Use of the verb "to comprise" and its conjugations does not exclude the presence of elements or steps other than those stated in a claim. Unless the context clearly requires otherwise, throughout the description and the claims, the words "comprise", "comprising", and the like are to be construed in an inclusive sense as opposed to an exclusive or exhaustive sense; that is to say, in the sense of "including, but not limited to".

The article "a" or "an" preceding an element does not exclude the presence of a plurality of such elements.

The invention may be implemented by means of hardware comprising several distinct elements, and by means of a suitably programmed computer. In a device claim, or an apparatus claim, or a system claim, enumerating several means, several of these means may be embodied by one and the same item of hardware. The mere fact that certain measures are recited in mutually different dependent claims does not indicate that a combination of these measures cannot be used to advantage.

The invention also provides a control system that may control the device, apparatus, or system, or that may execute the herein described method or process. Yet further, the invention also provides a computer program product, when running on a computer which is functionally coupled to or comprised by the device, apparatus, or system, controls one or more controllable elements of such device, apparatus, or system.

The invention further applies to a device, apparatus, or system comprising one or more of the characterizing features described in the description and/or shown in the attached drawings. The invention further pertains to a method or process comprising one or more of the characterizing features described in the description and/or shown in the attached drawings.

The various aspects discussed in this patent can be combined in order to provide additional advantages. Further, the person skilled in the art will understand that embodiments can be combined, and that also more than two embodiments can be combined. Furthermore, some of the features can form the basis for one or more divisional applications.

## Claims

1. A system (1000) comprising (i) a light emitting layer (100), (ii) a first lens (200), and a thermal conductor (300), wherein:
- the light emitting layer (100) comprises a luminescent material (150), wherein the luminescent material (150) is configured to generate luminescent material light (151) upon excitation with light source light (11) from a first laser light source (10) comprising a wavelength λ₁ selected from a wavelength in the UV, visible, and infrared, where the luminescent material (150) can be excited, wherein the light emitting layer (100) comprises a light receiving area (110) having a light receiving area size A₁;
- the first lens (200) comprises a truncated ball shaped lens (250) having a curved lens surface (215) having a radius Ro relative to a central point (O), and a planar lens surface (225) configured at a first distance d₁ from the central point (O), wherein the planar lens surface (225) has a planar lens surface area size A₂, wherein the first lens (200) comprises a lens material (205) having an index of refraction n at said predetermined wavelength λ₁, wherein d₁=x^{∗}R₀/n, wherein 0.9≤x≤1.1, wherein the planar lens surface area size A₂ is larger than the light receiving area size A₁, wherein the first lens (200) is configured to concentrate light received at the curved lens surface (215) to provide light emanating from the planar lens surface (225), wherein the planar lens surface (225) is directed to the light receiving area (110); and
- the thermal conductor (300) is configured in thermal contact with one or more of the light emitting layer (100) and the first lens (200),
- the system (1000) further comprising the first laser light source (10) configured to generate the first light source light (11), wherein the curved lens surface (215) is configured in a light receiving relationship with the first laser light source (10) and further comprising a second light source (20) configured to generate second light source light (21) having a spectral power distribution different from or equal to the first light source light (11) and different from the luminescent material light (151), wherein the system (1000) is configured to generate lighting system light (1001) comprising the luminescent material light (151) and wherein in an operation mode of the system (1000) the lighting system light (1001) further comprises the second light source light (21).

2. The system (1000) according to claim 1, wherein the light receiving area (110) is configured at an average second distance d₂ₐ selected from the range of 1-10 µm from the planar lens surface (225).

3. The system (1000) according to claim 1, wherein the light receiving area (110) is configured at an average second distance d₂ₐ selected from the range of < 1 µm from the planar lens surface (225).

4. The system (1000) according to any one of the preceding claims, wherein the first lens (200) has an external surface (230) comprising the curved lens surface (215) and the planar lens surface (225), wherein the first lens (200) is configured such that rays of luminescent material light (151) entering the first lens (200) via the planar lens surface (225) cannot directly reach a first external surface part (211) of the external surface (230), wherein the thermal conductor (300) is in thermal contact with the first lens (200) via the first external surface part (211).

5. The system (1000) according to any one of the preceding claims, wherein the first lens (200) comprises a ball part (210) comprising the curved lens surface (215) and a cylindrical part (220) comprising the planar lens surface (225), wherein the cylindrical part (220) has cylindrical shape or a tapered cylindrical shape, wherein the thermal conductor (300) is in thermal contact with the cylindrical part (220) but not in physical contact with the planar lens surface (225).

6. The system (1000) according to any one of the preceding claims, wherein λ₁ is 589.3 nm and the lens material (205) has an index of refraction n at 589.3 nm selected from the range of 1.4-1.9, wherein the lens material (205) comprises one or more of sapphire, MgO, CaF₂, quartz, BaF₂, M₃A₅O₁₂ garnet, ALON, MgAl₂O₄, and MgF₂, wherein the thermal conductor (300) comprises a heat sink, wherein the light emitting layer (100) comprises a ceramic body (155) comprising the luminescent material (150), and wherein 1.2≤A₂/A₁≤9.

7. The system (1000) according to any one of the preceding claims, wherein the light emitting layer (100) comprises a non-light receiving face (120), wherein the non-light receiving face (120) is not configured in a light receiving relationship with the first lens (200), wherein the thermal conductor (300) is in physical contact with at least part of the non-light receiving face (120) of the light emitting layer (100).

8. The system (1000) according to any one of the preceding claims, further comprising a control system, configured to control the lighting system light (1001) by controlling the first laser light source (10) and the second light source (20).

9. The system (1000) according to claim 1, wherein the first light source (10) comprises plurality of solid state light sources which together are configured to generate the first light source light (11), and wherein the lens material (205) comprises sapphire.

10. The system (1000) according to any one of the preceding claims, further comprising a second lens (1200), comprising an aspherical condenser lens (1250), configured upstream from the first lens (200) as seen from the first light source (10).

11. The system (1000) according to any one of the preceding claims, further comprising dichroic beam splitter optics (400), wherein the first light source (10) is configured to provide the first light source light (11) along a first optical path (51) in a first direction via the beam splitter optics (400) to the curved lens surface (215) of the first lens (200), and wherein the beam splitter optics (400) are configured to direct luminescent material light (151) received by the dichroic beam splitter optics (400) along a second optical path (52) not coinciding with the first optical path (51) in a second direction.

12. The system (1000) according to any one of the preceding claims, wherein the system (1000) is configured to provide in an operation mode white system light (1001).

13. A lighting device (1) comprising (i) the lighting system (1000) according to any one of the preceding claims and (ii) optionally further optics for shaping and/or modifying the system light (1001).

## Patentansprüche

1. System (1000), umfassend (i) eine lichtemittierende Schicht (100), (ii) eine erste Linse (200) und einen Wärmeleiter (300), wobei:
- die lichtemittierende Schicht (100) ein Lumineszenzmaterial (150) umfasst, wobei das Lumineszenzmaterial (150) konfiguriert ist, um Lumineszenzmaterial (151) bei Anregung mit Lichtquellenlicht (11) von einer ersten Laserlichtquelle (10) zu erzeugen, umfassend eine Wellenlänge λ₁, ausgewählt aus einer Wellenlänge in UV, sichtbar und Infrarot, wobei das Lumineszenzmaterial (150) angeregt werden kann, wobei die lichtemittierende Schicht (100) einen Lichtempfangsbereich (110) umfasst, der eine Lichtempfangsflächengröße A₁ aufweist;
- die erste Linse (200) eine verkürzte Kugellinse (250) umfasst, die eine gekrümmte Linsenfläche (215) aufweist, die einen Radius R₀ relativ zu einem Mittelpunkt (O) aufweist, und eine planare Linsenfläche (225), die in einem ersten Abstand d₁ vom Mittelpunkt (O) konfiguriert ist, wobei die planare Linsenfläche (225) eine planare Linsenflächengröße A₂ aufweist, wobei die erste Linse (200) ein Linsenmaterial (205) umfasst, das einen Brechungsindex n bei der vorbestimmten Wellenlänge λ₁ aufweist, wobei d₁=x^{∗}R₀/n, wobei 0,9≤x≤1,1, wobei die planare Linsenflächengröße A₂ größer als die Lichtempfangsfläche A₁ ist, wobei die erste Linse (200) konfiguriert ist, um Licht zu konzentrieren, das an der gekrümmten Linsenfläche (215) empfangen wird, um Licht bereitzustellen, das von der planaren Linsenfläche (225) ausgeht, wobei die planare Linsenfläche (225) auf den Lichtempfangsbereich (110) gerichtet ist; und
- der Wärmeleiter (300) in thermischem Kontakt mit einer oder mehreren von der lichtemittierenden Schicht (100) und der ersten Linse (200) konfiguriert ist,
- das System (1000) ferner umfassend die erste Laserlichtquelle (10), die konfiguriert ist, um das erste Lichtquellenlicht (11) zu erzeugen, wobei die gekrümmte Linsenfläche (215) in einer Lichtempfangsbeziehung mit der ersten Laserlichtquelle (10) konfiguriert ist, und ferner umfassend eine zweite Lichtquelle (20), die konfiguriert ist, um ein zweites Lichtquellenlicht (21) zu erzeugen, das eine spektrale Leistungsverteilung aufweist, die sich von dem ersten Lichtquellenlicht (11) unterscheidet oder gleich ist, und sich von dem Lumineszenzmaterial (151) unterscheidet, wobei das System (1000) konfiguriert ist, um Beleuchtungssystemlicht (1001) zu erzeugen, umfassend das Lumineszenzmaterial (151), und wobei in einem Betriebsmodus des Systems (1000) das Beleuchtungssystemlicht (1001) ferner das zweite Lichtquellenlicht (21) umfasst.

2. System (1000) nach Anspruch 1, wobei der Lichtempfangsbereich (110) in einem durchschnittlichen zweiten Abstand d₂ₐ konfiguriert ist, ausgewählt aus dem Bereich von 1-10 µm von der planaren Linsenfläche (225).

3. System (1000) nach Anspruch 1, wobei der Lichtempfangsbereich (110) in einem durchschnittlichen zweiten Abstand d₂ₐ konfiguriert ist, ausgewählt aus dem Bereich von < 1 µm von der planaren Linsenfläche (225).

4. System (1000) nach einem der vorstehenden Ansprüche, wobei die erste Linse (200) eine Außenfläche (230) aufweist, umfassend die gekrümmte Linsenfläche (215) und die planare Linsenfläche (225), wobei die erste Linse (200) so konfiguriert ist, dass Strahlen von Lumineszenzmateriallicht (151), das über die planare Linsenfläche (225) in die erste Linse (200) eintritt, nicht direkt in einen ersten Außenflächenabschnitt (211) der Außenfläche (230) gelangen kann, wobei der Wärmeleiter (300) über den ersten Außenflächenabschnitt (211) mit der ersten Linse (200) in thermischem Kontakt steht.

5. System (1000) nach einem der vorstehenden Ansprüche, wobei die erste Linse (200) ein Kugelteil (210) umfasst, umfassend die gekrümmte Linsenfläche (215) und einen zylindrischen Teil (220), umfassend die planare Linsenfläche (225), wobei der zylindrische Teil (220) eine zylindrische Form oder eine konische zylindrische Form aufweist, wobei der Wärmeleiter (300) in thermischem Kontakt mit dem zylindrischen Teil (220), aber nicht in physischem Kontakt mit der planaren Linsenfläche (225) steht.

6. System (1000) nach einem der vorstehenden Ansprüche, wobei λ₁ 589,3 nm ist, und das Linsenmaterial (205) einen Brechungsindex n bei 589,3 nm aufweist, ausgewählt aus dem Bereich von 1,4-1,9, wobei das Linsenmaterial (205) eines oder mehrere von Saphir, MgO, CaF₂, Quarz, BaF₂, M₃A₅O₁₂ Granat, ALON, MgA1₂O₄ und MgF₂ umfasst, wobei der Wärmeleiter (300) eine Wärmesenke umfasst, wobei die lichtemittierende Schicht (100) einen Keramikkörper (155) umfasst, der das Lumineszenzmaterial (150) umfasst, und wobei 1,2≤A₂/A₁≤9.

7. System (1000) nach einem der vorstehenden Ansprüche, wobei die lichtemittierende Schicht (100) eine Nicht-Lichtempfangsfläche (120) umfasst, wobei die Nicht-Lichtempfangsfläche (120) nicht in einer Lichtempfangsbeziehung mit der ersten Linse (200) konfiguriert ist, wobei der Wärmeleiter (300) in physischem Kontakt mit mindestens einem Teil der Nicht-Lichtempfangsfläche (120) der lichtemittierenden Schicht (100) ist.

8. System (1000) nach einem der vorstehenden Ansprüche, ferner umfassend ein Steuersystem, das konfiguriert ist, um das Beleuchtungssystemlicht (1001) durch Steuern der ersten Laserlichtquelle (10) und der zweiten Lichtquelle (20) zu steuern.

9. System (1000) nach Anspruch 1, wobei die erste Lichtquelle (10) eine Mehrzahl von Festkörperlichtquellen umfasst, die zusammen konfiguriert sind, um das erste Lichtquellenlicht (11) zu erzeugen, und wobei das Linsenmaterial (205) Saphir umfasst.

10. System (1000) nach einem der vorstehenden Ansprüche, ferner umfassend eine zweite Linse (1200), umfassend eine asphärische Kondensatorlinse (1250), die stromaufwärts von der ersten Linse (200) konfiguriert ist, wie von der ersten Lichtquelle (10) gesehen.

11. System (1000) nach einem der vorstehenden Ansprüche, ferner umfassend eine dichroitische Strahlteileroptik (400), wobei die erste Lichtquelle (10) konfiguriert ist, um das erste Lichtquellenlicht (11) entlang eines ersten optischen Pfads (51) in einer ersten Richtung über die Strahlteileroptik (400) für die gekrümmte Linsenfläche (215) der ersten Linse (200) bereitzustellen, und wobei die Strahlteileroptik (400) konfiguriert ist, um Lumineszenzmaterial (151), das von der dichroitischen Strahlteileroptik (400) entlang eines zweiten optischen Pfads (52) empfangen wird, der nicht mit dem ersten optischen Pfad (51) zusammenfällt, in einer zweiten Richtung zu leiten.

12. System (1000) nach einem der vorstehenden Ansprüche, wobei das System (1000) konfiguriert ist, um in einem Betriebsmodus weißes Systemlicht (1001) bereitzustellen.

13. Beleuchtungsvorrichtung (1), umfassend (i) das Beleuchtungssystem (1000) nach einem der vorstehenden Ansprüche und (ii) optional weitere Optik zum Formen und/oder Modifizieren des Systemlichts (1001).

## Revendications

1. Système (1000) comprenant (i) une couche émettrice de lumière (100), (ii) une première lentille (200) et un conducteur thermique (300), dans lequel :
- la couche émettrice de lumière (100) comprend un matériau luminescent (150), dans lequel le matériau luminescent (150) est conçu pour générer de la lumière de matériau luminescent (151) lors d'une excitation avec de la lumière de source de lumière (11) provenant d'une première source de lumière laser (10) comprenant une longueur d'onde λ₁ choisie parmi une longueur d'onde dans l'UV, le visible et l'infrarouge, à laquelle le matériau luminescent (150) peut être excité, dans lequel la couche émettrice de lumière (100) comprend une zone de réception de lumière (110) ayant une taille de zone de réception de lumière λ₁ ;
- la première lentille (200) comprend une lentille en forme de bille tronquée (250) ayant une surface courbe de lentille (215) ayant un rayon Ro par rapport à un point central (O) et une surface plane de lentille (225) conçue à une première distance d₁ du point central (O), dans lequel la surface plane de lentille (225) a une taille de zone de surface plane de lentille A₂, dans lequel la première lentille (200) comprend un matériau de lentille (205) ayant un indice de réfraction n à ladite longueur d'onde prédéterminée λ₁, dans lequel d₁=x^{∗}R₀/n, dans lequel 0,9≤x≤1,1, dans lequel la taille de zone de surface plane de lentille A₂ est plus grande que la taille de zone de réception de lumière A₁, dans lequel la première lentille (200) est conçue pour concentrer de la lumière reçue au niveau de la surface courbe de lentille (215) pour fournir de la lumière émanant de la surface plane de lentille (225), dans lequel la surface plane de lentille (225) est dirigée vers la zone de réception de lumière (110) ; et
- le conducteur thermique (300) est conçu en contact thermique avec une ou plusieurs de la couche émettrice de lumière (100) et de la première lentille (200),
- le système (1000) comprenant en outre la première source de lumière laser (10) conçue pour générer la lumière de première source de lumière (11), dans lequel la surface courbe de lentille (215) est conçue dans une relation de réception de lumière avec la première source de lumière laser (10) et comprenant en outre une deuxième source de lumière (20) conçue pour générer de la lumière de deuxième source de lumière (21) ayant une distribution de puissance spectrale différente de ou égale à la lumière de première source de lumière (11) et différente de la lumière de matériau luminescent (151), dans lequel le système (1000) est conçu pour générer de la lumière de système d'éclairage (1001) comprenant la lumière de matériau luminescent (151) et dans lequel dans un mode de fonctionnement du système (1000) la lumière de système d'éclairage (1001) comprend en outre la lumière de deuxième source de lumière (21).

2. Système (1000) selon la revendication 1, dans lequel la zone de réception de lumière (110) est conçue à une deuxième distance moyenne d₂ₐ choisie dans la plage de 1 à 10 µm par rapport à la surface plane de lentille (225).

3. Système (1000) selon la revendication 1, dans lequel la zone de réception de lumière (110) est conçue à une deuxième distance moyenne d₂ₐ choisie dans la plage < 1 µm par rapport à la surface plane de lentille (225).

4. Système (1000) selon l'une quelconque des revendications précédentes, dans lequel la première lentille (200) a une surface externe (230) comprenant la surface courbe de lentille (215) et la surface plane de lentille (225), dans lequel la première lentille (200) est conçue de telle sorte que des rayons de lumière de matériau luminescent (151) pénétrant dans la première lentille (200) par l'intermédiaire de la surface plane de lentille (225) ne puissent pas atteindre directement une première partie de surface externe (211) de la surface externe (230), dans lequel le conducteur thermique (300) est en contact thermique avec la première lentille (200) par l'intermédiaire de la première partie de surface externe (211).

5. Système (1000) selon l'une quelconque des revendications précédentes, dans lequel la première lentille (200) comprend une partie bille (210) comprenant la surface courbe de lentille (215) et une partie cylindrique (220) comprenant la surface plane de lentille (225), dans lequel la partie cylindrique (220) a une forme cylindrique ou une forme cylindrique effilée, dans lequel le conducteur thermique (300) est en contact thermique avec la partie cylindrique (220) mais pas en contact physique avec la surface plane de lentille (225).

6. Système (1000) selon l'une quelconque des revendications précédentes, dans lequel λ₁ vaut 589,3 nm et le matériau de lentille (205) a un indice de réfraction n à 589,3 nm choisi dans la plage de 1,4 à 1,9, dans lequel le matériau de lentille (205) comprend un ou plusieurs parmi saphir, MgO, CaF₂, quartz, BaF₂, grenat M₃A₅O₁₂, ALON, MgAl₂O₄, et MgF₂, dans lequel le conducteur thermique (300) comprend un puits thermique, dans lequel la couche émettrice de lumière (100) comprend un corps en céramique (155) comprenant le matériau luminescent (150) et dans lequel 1,2≤A₂/A₁≤9.

7. Système (1000) selon l'une quelconque des revendications précédentes, dans lequel la couche émettrice de lumière (100) comprend une face ne recevant pas de lumière (120), dans lequel la face ne recevant pas de lumière (120) n'est pas conçue dans une relation de réception de lumière avec la première lentille (200), dans lequel le conducteur thermique (300) est en contact physique avec au moins une partie de la face ne recevant pas de lumière (120) de la couche émettrice de lumière (100).

8. Système (1000) selon l'une quelconque des revendications précédentes, comprenant en outre un système de commande, configuré pour commander la lumière de système d'éclairage (1001) en commandant la première source de lumière laser (10) et la deuxième source de lumière (20).

9. Système (1000) selon la revendication 1, dans lequel la première source de lumière (10) comprend une pluralité de sources de lumière à semi-conducteurs qui ensemble sont conçues pour générer la lumière de première source de lumière (11) et dans lequel le matériau de lentille (205) comprend du saphir.

10. Système (1000) selon l'une quelconque des revendications précédentes, comprenant en outre une deuxième lentille (1200), comprenant une lentille de condenseur asphérique (1250), conçue en amont de la première lentille (200) comme observé à partir de la première source de lumière (10).

11. Système (1000) selon l'une quelconque des revendications précédentes, comprenant en outre des optiques de diviseur de faisceau dichroïques (400), dans lequel la première source de lumière (10) est conçue pour fournir la lumière de première source de lumière (11) le long d'un premier trajet optique (51) dans une première direction par l'intermédiaire des optiques de diviseur de faisceau (400) à la surface courbe de lentille (215) de la première lentille (200) et dans lequel les optiques de diviseur de faisceau (400) sont conçues pour diriger de la lumière de matériau luminescent (151) reçue par les optiques de diviseur de faisceau dichroïques (400) le long d'un deuxième trajet optique (52) ne coïncidant pas avec le premier trajet optique (51) dans une deuxième direction.

12. Système (1000) selon l'une quelconque des revendications précédentes, dans lequel le système (1000) est conçu pour fournir dans un mode de fonctionnement de la lumière blanche de système (1001).

13. Dispositif d'éclairage (1) comprenant (i) le système d'éclairage (1000) selon l'une quelconque des revendications précédentes et (ii) facultativement des optiques supplémentaires pour la mise en forme et/ou la modification de la lumière de système (1001).
